# EUROPÄISCHE PATENTSCHRIFT

(11) **EP 2 482 625 B1**
(45) Veröffentlichungstag und Bekanntmachung des Hinweises auf die Patenterteilung: **18.09.2013**
(21) Anmeldenummer: 12152753.5
(22) Anmeldetag: 26.01.2012
(51) Int. Cl.: H05K 3/00

(54) **Leiterplattentrenneinrichtung**
Circuit board separation device
Dispositif de séparation de plaquettes

(30) Priorität: 26.01.2011 DE 102011009507
(43) Veröffentlichungstag der Anmeldung: 01.08.2012
(73) Patentinhaber: SCHUNK Electronic Solutions GmbH, 78112 St. Georgen (DE)
(72) Erfinder: Lorenz, Stefan, 91338 Igensdorf (DE)
(74) Vertreter: Dreiss

(56) Entgegenhaltungen:
- DE-U1-202009 015 945
- US-A1- 2007 113 717
- US-A1- 2010 050 365

## Beschreibung

Die Erfindung betrifft eine Leiterplattentrenneinrichtung mit den Merkmalen des Oberbegriffs des Patentanspruchs 1.

Leiterplattentrenneinrichtungen sind aus der DE 20 2009 015 945 U1 bekannt. Diese ermöglichen eine schnelle und flexible Bestückung des Werkstückträgers mit unterschiedlichen Leiterplattensubstraten.

Eine weitere Leiterplattentrenneinrichtung gemäß dem Oberbegriff des Anspruchs 1 ist aus der US 2010/0050365 A1 bekannt. Bei dieser Leiterplattentrenneinrichtung ist ein Abdeckelement zur Abdeckung eines Leiterplattensubstrats vorgesehen, wobei das Abdeckelement über Scharniere verschwenkbar an einem Träger gehalten ist und mit diesem über Magnete in einer geschlossenen Schwenkstellung verbindbar ist.

Aus der US 2007/0113717 A1 ist eine weitere Leiterplattentrenneinrichtung bekannt. Bei dieser Leiterplattentrenneinrichtung ist ein Abdeckelement bekannt, das mittels Schraub- oder Rastverbindungen an einer Basis gesichert wird.

Der vorliegenden Erfindung liegt die Aufgabe zugrunde, eine Leiterplattentrenneinrichtung zu schaffen, welche sich besonders gut für eine Vereinzelung von Leiterplattensubstraten mit unterschiedlichen Layouts eignet.

Diese Aufgabe wird bei einer Leiterplattentrenneinrichtung der eingangs genannten Art erfindungsgemäß mit den kennzeichnenden Merkmalen des Anspruchs 1 gelöst.

Die erfindungsgemäße Leiterplattentrenneinrichtung umfasst eine Abdeckeinrichtung, welche mehrere Funktionen hat. Eine erste Funktion besteht darin, im Bereich von Abdeckabschnitten das Leiterplattensubstrat beziehungsweise im Zuge der Trennbearbeitung vereinzelte Leiterplatten zumindest abschnittsweise zu überlappen. Durch diese Überlappung kann verhindert werden, dass eine vereinzelte Leiterplatte von den Halteelementen und/oder Stützeelementen gelöst wird, beispielsweise durch Absaugen mittels einer Absaugeinrichtung. Eine Absaugeinrichtung ist insbesondere dann vorteilhaft, wenn die Vereinzelung der Leiterplatten mittels einer mechanischen Trennbearbeitung des Leiterplattensubstrats erfolgt, insbesondere mittels eines Fräsers. Die im Verlauf eines Fräsvorgangs durch Bearbeitung des Leiterplattensubstrats entstehenden Partikel oder Späne können mit Hilfe der Absaugeinrichtung abgesaugt werden, wodurch das Leiterplattensubstrat beziehungsweise die vereinzelten Leiterplatten mit diesen Partikeln oder Spänen nicht verunreinigt werden. Dies ist insbesondere vorteilhaft, wenn die Vereinzelung des Leiterplattensubstrats in Leiterplatten zu einem Zeitpunkt erfolgt, wenn das Leiterplattensubstrat bereits mit elektronischen Bauteilen bestückt ist.

Die Abdeckeinrichtung weist zusätzlich zu den Abdeckabschnitten mindestens eine Aussparung auf, welche eine Zugangspassage für die Trenneinrichtung zu dem Leiterplattensubstrat bildet. Auf diese Weise ist gewährleistet, dass die Trenneinrichtung in Eingriff mit dem Leiterplattensubstrat gebracht werden kann, jedoch lokal begrenzt und nur in einem von der Aussparung begrenzten Bereich. Vorzugsweise ist die mindestens eine Aussparung umfangsseitig geschlossen; zusätzlich oder alternativ hierzu ist aber auch möglich, mindestens eine randseitig offene Aussparung vorzusehen.

Die Abdeckeinrichtung ist vorzugsweise einstückig. Es ist aber auch möglich, voneinander separate Abdeckelemente vorzusehen. Dabei ist es auch möglich, dass eine Aussparung von zwei oder mehr Abdeckelementen gemeinsam begrenzt ist.

In vorteilhafter Weise ist die Abdeckeinrichtung plattenförmig ausgebildet, insbesondere als dünne Platte mit einer Wandstärke von wenigen Millimetern, beispielsweise zwischen ungefähr 1 mm und ungefähr 8 mm. Dies hat den Vorteil, dass die Zugangspassage eine relativ kleine Höhe aufweist, sodass die Trenneinrichtung, insbesondere das Trennwerkzeug der Trenneinrichtung, nur eine geringe zusätzliche Höhe überwinden muss, um in Eingriff mit dem Leiterplattensubstrat zu gelangen.

In vorteilhafter Weise sind die Aussparungen der Abdeckeinrichtung nur geringfügig größer als es für die Trennbearbeitung eines bestimmten Abschnitts des Leiterplattensubstrats erforderlich ist. Hierdurch kann die Abdeckwirkung der Abdeckeinrichtung maximiert werden, und zwar im Hinblick auf ein Verhindern des Ablösens von vereinzelten Leiterplatten und im Hinblick auf möglichst saubere Fertigungsbedingungen für eine maximale Wirksamkeit einer Absaugeinrichtung.

Die Abdeckeinrichtung ist an der Grundbasis festlegbar und/oder auf der Grundbasis abstützbar. Auf diese Weise kann eine einfache Lagedefinition zwischen Grundplatte, Leiterplattensubstrat und Abdeckeinrichtung geschaffen werden.

Zur flexiblen und einfachen Befestigung und/oder Abstützung des Leiterplattensubstrats ist es bevorzugt, wenn der Werkstückträger mit der Grundbasis zusammenwirkende Halteelemente und/oder Stützelemente für das Leiterplattensubstrat umfasst.

Erfindungsgemäß sind Zusatzhalteelemente zur Festlegung der Abdeckeinrichtung an der Grundbasis vorgesehen.

Insbesondere bei relativ dünnen Abdeckeinrichtungen ist es bevorzugt, wenn Zusatzstützelemente zur Abstützung der Abdeckeinrichtung vorgesehen sind, welche einer Durchbiegung der Abdeckeinrichtung entgegenwirken.

Erfindungsgemäß ist vorgesehen, dass die Zusatzhalteelemente und/oder die Zusatzstützelemente variabel auf der Grundbasis positionierbar sind.

Bei einer bevorzugten Ausführungsform der Erfindung ist vorgesehen, dass die Zusatzhalteelemente mit den Halteelementen und/oder dass die Zusatzstützelemente mit den Stützelementen baugleich sind, wobei die Zusatzhalteelemente und/oder die Zusatzstützelemente eine größere wirksame Bauhöhe aufweisen als die Halteelemente und/oder Stützelemente, sodass die Abdeckeinrichtung in einem größeren Abstand zu der Grundbasis festlegbar und/oder abstützbar ist als das Leiterplattensubstrat. Die jeweilige wirksame Bauhöhe ist definiert durch den Abstand, mit welchem das Leiterplattensubstrat beziehungsweise die Abdeckeinrichtung zu der Grundbasis festlegbar und/oder abstützbar ist.

Bevorzugt ist es, wenn die beiden Bauhöhen nur geringfügig voneinander abweichen, sodass die Abdeckeinrichtung relativ gering zu dem Leiterplattensubstrat beabstandet ist, beispielsweise mit einem Abstand von nur wenigen Millimetern, vorzugsweise mit einem Abstand zwischen ungefähr 0,5 mm und ungefähr 10 mm. Dies ist insbesondere bei einer mechanischen Trenneinrichtung in Form eines Fräswerkzeugs mit einem Durchmesser von nur wenigen Millimetern (beispielsweise zwischen ungefähr 1 mm und ungefähr 4 mm) vorteilhaft. Durch die Minimierung des Abstands zwischen der Abdeckeinrichtung und dem Leiterplattensubstrat kann die ungeführte Höhe eines solchen Trennwerkzeugs verringert und das Risiko eines Werkzeugbruchs minimiert werden.

Zur Festlegung der Zusatzhalteelemente und/oder der Zusatzstützelemente ist im Rahmen der Erfindung vorgesehen, dass diese Elemente jeweils Fußabschnitte aufweisen, welche magnetisch mit der Grundbasis zusammenwirken. Zur Festlegung der Halteelemente und/oder der Stützelemente ist es bevorzugt, wenn diese Elemente jeweils Fußabschnitte aufweisen, welche magnetisch mit der Grundbasis zusammenwirken. Dies ermöglicht ein im Prinzip beliebige Positionierung der genannten Elemente an der Grundbasis, wodurch in einfacher Weise Leiterplattensubstrate mit unterschiedlichen Layouts trennbearbeitend vereinzelt und dabei mittels einer auf das jeweilige Layout abgestimmten Abdeckeinrichtung abgedeckt werden können.

Die Abdeckeinrichtung weist vorzugsweise ein individuell auf ein bestimmtes Leiterplattensubstrat abgestimmtes Layout aus Abdeckabschnitten und Aussparungen auf, sodass zumindest ein Abschnitt der Kontur im Zuge der Trennbearbeitung vereinzelten Leiterplatte von mindestens einem Abdeckabschnitt der Abdeckeinrichtung abgedeckt ist.

Beispielsweise handelt es sich bei der Abdeckeinrichtung um eine Platte aus Kunststoff, welche in einfacher Weise mechanisch bearbeitet werden kann, sodass ausgehend von einer durchgehenden Abdeckfläche Aussparungen eingebracht werden, deren Lage, Form, Ausrichtung und Größe jeweils auf die zu trennbearbeitenden Bereiche eines bestimmten Leiterplattensubstrats abgestimmt sind.

Bei einer besonders bevorzugten Ausführungsform ist vorgesehen, dass die Abdeckeinrichtung mindestens eine Zusatzaussparung aufweist, welche zur Aufnahme eines an dem Leiterplattensubstrat befestigten Bauteils dient, sodass während der Trennbearbeitung dieses Bauteil die Zusatzaussparung der Abdeckeinrichtung durchsetzt. Die Zusatzaussparung ermöglicht es also, bei einem bereits bestückten Leiterplattensubstrat die Abdeckeinrichtung mit nur geringem Abstand zu dem Leiterplattensubstrat selbst anordnen zu können. Dabei durchsetzt das Bauteil die Zusatzaussparung und ragt gegebenenfalls über die Abdeckeinrichtung hinaus.

Bei der Trenneinrichtung handelt es sich vorzugsweise um eine mechanisch wirksame Trenneinrichtung, welche im Zuge der Trennbearbeitung des Leiterplattensubstrats Leiterplattensubstratpartikel oder -späne erzeugt, die mittels einer Absaugeinrichtung abgesaugt werden. Vorzugsweise handelt es sich bei der Trenneinrichtung um ein Spanwerkzeug, insbesondere um ein Fräswerkzeug. Die Trenneinrichtung ist bei einer bevorzugten Ausführungsform numerisch steuerbar positionierbar.

Bevorzugt ist es ferner, wenn eine magazinartige Aufnahme für eine Mehrzahl von Halteelementen und/oder Stützelementen und für eine Mehrzahl von Zusatzhalteelementen und/oder Zusatzstützelementen vorgesehen ist, und wenn eine Handhabungseinrichtung vorgesehen ist, mittels welcher zum Einen die Halteelemente und/oder Stützeelemente und zum Anderen die Zusatzhalteelemente und/oder Zusatzstützelemente aus der Aufnahme entnehmbar und auf der Grundbasis positionierbar sind, wobei die Entnahme und Positionierung sowohl der Halteelemente und/oder Stützelemente als auch der Zusatzhalteelemente und/oder Zusatzstützelemente numerisch gesteuert durchführbar ist. Auf diese Weise kann bei einer Trennbearbeitung unterschiedlicher Leiterplattensubstrate unter Verwendung unterschiedlicher Abdeckeinrichtungen jeweils eine schnelle Befestigung und/oder Abstützung sowohl des Leiterplattensubstrats als auch der Abdeckeinrichtung an der Grundbasis erfolgen.

Weitere Merkmale und Vorteile der Erfindung sind Gegenstand der nachfolgenden Beschreibung und der zeichnerischen Darstellung eines bevorzugten Ausführungsbeispiels.

In den Zeichnungen zeigen:

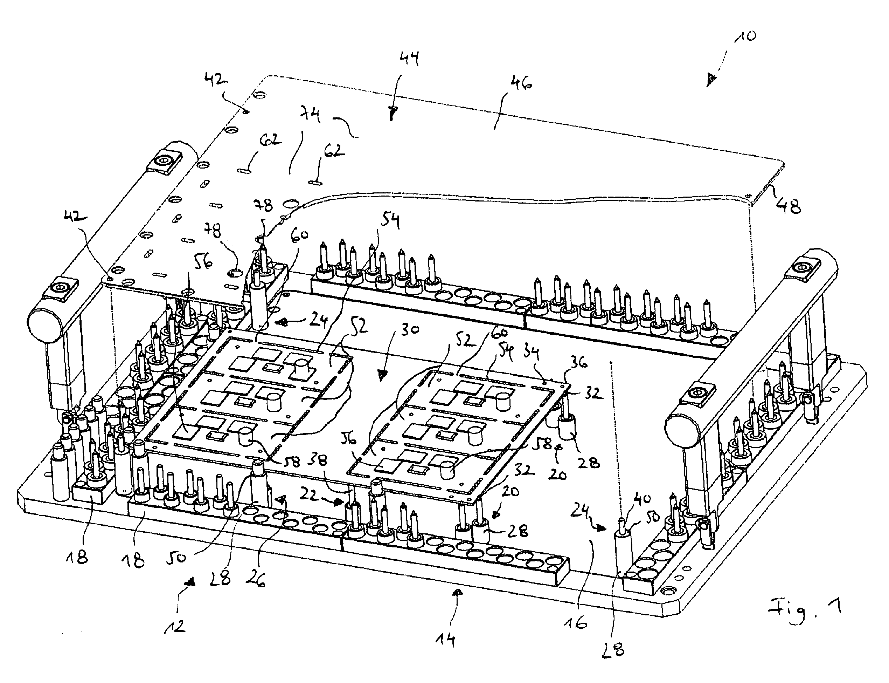

- Fig. 1: eine perspektivische Ansicht einer Ausführungsform einer Leiterplattentrenneinrichtung in einer Explosionsdarstellung; und
- Fig. 2: eine perspektivische Ansicht der Leiterplattentrenneinrichtung gemäß Fig. 1 in einer Zusammenstellungsdarstellung.

Eine Ausführungsform einer Leiterplattentrenneinrichtung ist in der Zeichnung insgesamt mit dem Bezugzeichen 10 bezeichnet. Die Leiterplattentrenneinrichtung 10 umfasst einen insgesamt mit dem Bezugszeichen 12 bezeichneten Werkstückträger. Der Werkstückträger 12 umfasst eine Grundbasis 14, welche insbesondere in Form einer magnetischen Grundplatte 16 ausgebildet ist. Die Grundplatte 16 erstreckt sich über einen Arbeitsbereich, welcher beispielsweise rechteckförmig ist.

Der Werkstückträger 12 umfasst ferner mindestens eine magazinartige Aufnahme 18, welche vorzugsweise in räumlicher Nähe zu der Grundbasis 14 angeordnet ist, insbesondere in Randbereichen der Grundbasis 14 angeordnet und festgelegt sind.

Die magazinartigen Aufnahmen 18 dienen zur Bevorratung von Halteelementen 20 und Stützelementen 22. Ferner dienen die Aufnahme 18 zur Bevorratung von Zusatzhalteelementen 24 und Zusatzstützelementen 26. Die Elemente 20 bis 26 weisen jeweils einen magnetisch wirksamen Fußabschnitt 28 auf, welcher bei Anordnung des Elements auf der Grundplatte 16 magnetisch mit dieser zusammenwirkt.

Die Halteelemente 20 dienen zur Fixierung eines Leiterplattensubstrats 30 an der Grundplatte 16 des Werkstückträgers 12. Hierfür weisen die Halteelemente 20 Halteabschnitte 32 auf, welche zum Eingriff von Halteaufnehmungen 34 des Leiterplattensubstrats 30 oder zur Anlage gegen eine Berandung 36 des Leiterplattensubstrats 30 ausgebildet sind.

Die Stützelemente 22 weisen einen Abstützabschnitt 38 auf, welcher zur Anlage gegen eine Unterseite des Leiterplattensubstrats 30 dient.

Die Zusatzhalteelemente 24 weisen Zusatzhalteabschnitte 40 auf, welche den Halteabschnitten 32 der Halteelemente 20 entsprechen und welche zum Eingriff in Zusatzausnehmungen 42 einer Abdeckeinrichtung 44 dienen.

Die Abdeckeinrichtung 44 ist insbesondere in Form einer Abdeckplatte 46 ausgebildet, welche vorzugsweise parallel zu dem Leiterplattensubstrat 30 und der Grundbasis 14 anordenbar ist. Die Zusatzhalteabschnitte 40 der Zusatzhalteelemente 24 dienen optional auch zur Anlage an eine Berandung 48 der Abdeckeinrichtung 44.

Die Zusatzstützelemente 24 weisen vorzugsweise benachbart zu den Zusatzhalteabschnitten 40 eine beispielsweise ringförmige Anlagefläche 50 auf, welche zur Anlage einer Unterseite der Abdeckeinrichtung 44 dient. Die wirksame Bauhöhe des Zusatzstützelements 24 ist gleich dem Abstand zwischen der Unterseite des Fußabschnitts 28 und der Anlagefläche 50.

Das Leiterplattensubstrat 30 weist mindestens eine Leiterplatte 52, vorzugsweise eine Mehrzahl von Leiterplatten 52 auf. In dem in der Zeichnung dargestellten Ausführungsbeispiel weist das Leiterplattensubstrat 30 sechs Leiterplatten 52 auf.

Das Leiterplattensubstrat 30 wird ausgehend von einer geschlossenen Substratfläche hergestellt, indem zunächst Konturen 54 der Leiterplatten 52 abschnittsweise in die geschlossene Substratfläche eingebracht werden. Dieser Arbeitsschritt wird üblicherweise vor einer Bestückung des Leiterplattensubstrats 30 mit Bauteilen 56, 58 durchgeführt, sodass diese Bauteile nicht durch die Herstellung der abschnittsweisen Konturen 54 bedingt verunreinigt werden können.

Im Anschluss an die Herstellung der abschnittsweise Konturen 54 verbleiben Trennbereiche 60, welche für eine Vereinzelung der Leiterplatten 52 von dem Leiterplattensubstrat 30 noch durchtrennt werden müssen.

Üblicherweise erfolgt im Anschluss an die Herstellung der abschnittsweisen Konturen die Bestückung des Leiterplattensubstrats 30 mit (insbesondere elektronischen) Bauteilen 56, 58.

Anschließend wird das mit abschnittsweisen Konturen 54 versehene und bestückte Leiterplattensubstrat 30 an der Grundbasis 14 festgelegt, insbesondere durch Aufstecken des Leiterplattensubstrats 30 auf die Halteabschnitte 32 der Halteelemente 20. Hierbei kann eine numerisch gesteuerte Entnahme der Halteelemente 20 aus den magazinartigen Aufnahmen 18 erfolgen, wie dies in der DE 20 2009 015 945 U1 beschrieben und daher an dieser Stelle nicht weiter erläutert ist. Bei Bedarf können auch Stützelemente 22 zur Abstützung des Leiterplattensubstrats 30 in entsprechender Weise positioniert werden.

Vor der Durchtrennung der Trennbereiche 60 wird die Abdeckeinrichtung 44 an dem Werkstückträger 12 festgelegt, vorzugsweise unter Verwendung der Zusatzhalteelemente 24 und bedarfsweise unter Verwendung von Zusatzstützelementen 26.

Die Abdeckplatte 46 weist mindestens eine Aussparung 62, vorzugsweise eine Mehrzahl von Aussparungen 62 auf. Die Aussparungen 62 sind beispielsweise langlochförmig. Die Aussparungen 62 sind geringfügig größer als die Trennbereiche 60 des Leiterplattensubstrats 30.

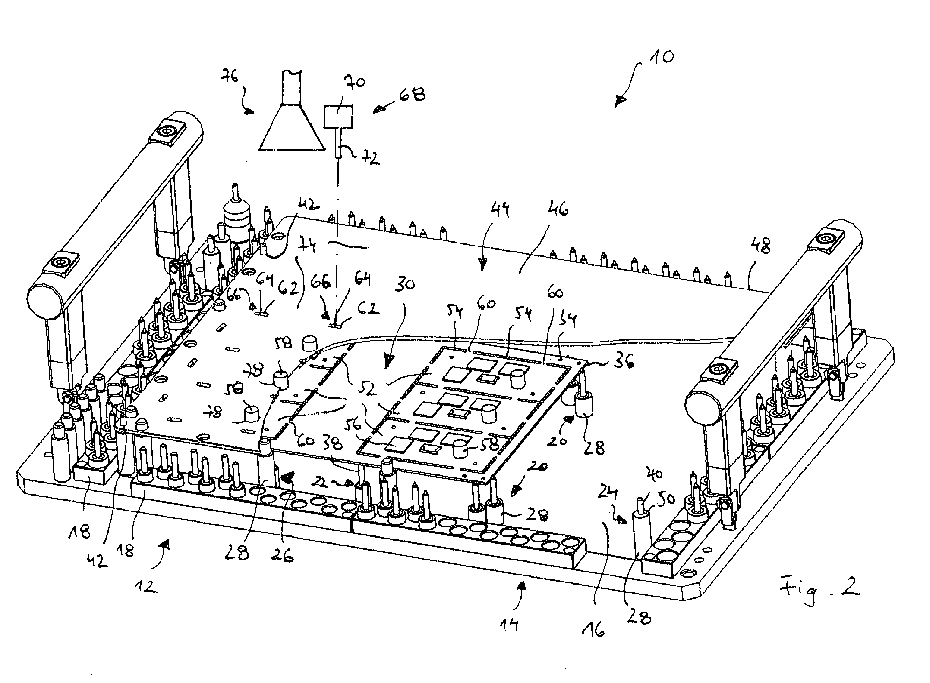

Die Lage, Form, Ausrichtung und Größe der Aussparungen 62 ist auf die Lage, Form, Ausrichtung und Größe der Trennbereiche 60 des Leiterplattensubstrats 30 abgestimmt. Die Aussparungen 62 begrenzen Freiräume 64, welche eine Zugangspassage 66 für eine in Figur 2 schematisch dargestellte Trenneinrichtung 68 bilden. Der Querschnitt einer Zugangspassage 66 ist vorzugsweise nur geringfügig größer als ein dieser Zugangspassage 66 zugeordneter Trennbereich 60.

Die Trenneinrichtung 68 weist einen Antrieb 70 für ein Trennwerkzeug 72 auf. Die Trenneinrichtung 68 ist vorzugsweise numerisch gesteuert positionierbar, und zwar in einer Ebene parallel zu der Grundplatte 16 und in einer Richtung senkrecht zu der Grundbasis 14.

Bei dem Trennwerkzeug 72 handelt es sich insbesondere um ein Fräswerkzeug. Vorzugsweise weist das Trennwerkzeug 72 einen Durchmesser auf, welcher nur geringfügig kleiner ist als der kleinste Abstand zwischen gegenüberliegenden Begrenzungen der Aussparungen 62.

Das Material der Abdeckplatte 46 außerhalb der Aussparungen 62 bildet Abdeckabschnitte 74, welche vorzugsweise ineinander übergehen, sodass eine einstückige Abdeckplatte 46 geschaffen wird.

Zur Trennbearbeitung der Trennbereiche 60 mittels des Trennwerkzeugs 72 wird die Trenneinrichtung 68 so positioniert, dass das Trennwerkzeug 72 eine Aussparung 62 durchsetzt und in Eingriff mit dem dieser Aussparung zugeordneten Trennbereich 60 gelangt. Dabei ist das Leiterplattensubstrat 30 im Bereich außerhalb der Aussparungen 62 mittels der Abdeckabschnitte 74 von der Abdeckeinrichtung 46 abgedeckt. Hierdurch wird verhindert, dass im Zuge der Vereinzelung entstehende Leiterplatten 52 von den Halteelementen 20 (und gegebenenfalls von den Stützelementen 22) von einer Absaugeinrichtung 76 abgesaugt werden (in Figur 2 schematisch dargestellt). Die Absaugeinrichtung 76 dient dazu, die im Zuge der Trennbearbeitung entstehenden Verunreinigungen (Partikel, Späne) abzusaugen. Die Absaugeinrichtung 76 soll jedoch gerade nicht die vereinzelten Leiterplatten 52 mit ansaugen; diese sollen vielmehr an den Halteelementen 20 beziehungsweise Stützelementen 22 verbleiben.

Die durch die Anlageflächen 50 vorgegebenen Bauhöhen der Zusatzstützelementen 24 sind nur geringfügig höher als die in entsprechender Weise definierten Bauhöhen der Halteelemente 20 zuzüglich der Bauhöhe des Leiterplattensubstrats 30. Auf diese Weise kann die Unterseite der Abdeckeinrichtung 44 in eine räumliche Nähe von wenigen Millimetern zu der Oberseite des Leiterplattensubstrats 30 gebracht werden. Dadurch, dass ferner die Stärke der Abdeckplatte 46 nur wenige Millimeter beträgt, ist eine nur geringe Arbeitshöhe des Trennwerkzeugs 72 erforderlich, sodass eine präzise und auswanderungsfreie Bearbeitung der Trennbereiche 60 ermöglicht wird. Außerdem wird das Risiko des Abbruchs des Trennwerkzeug 72 minimiert.

Um die vorstehend beschriebene geringe Beabstandung der Abdeckeinrichtung 44 zu dem Leiterplattensubstrat 30 auch bei Bauteilen 58 mit größerer Bauhöhe zu gewährleisten, ist bei einer bevorzugten Ausführungsform vorgesehen, dass die Abdeckeinrichtung 44 zusätzlich zu den Aussparungen 62 noch Zusatzaussparungen 78 aufweist, welche in der in der Figur 2 dargestellten Gebrauchslage der Abdeckeinrichtung 44 von den höher bauenden Bauteilen 78 durchsetzt sind. Die Zusatzaussparungen 78 sind im Querschnitt vorzugsweise nur geringfügig größer als die Bauteile 58, sodass die Abdeckwirkung der Abdeckeinrichtung 44 maximiert wird. Die Lage, Form, Ausrichtung und Größe der Zusatzaussparungen 58 ist auf die Lage, Form, Ausrichtung und Größe der Bauteile 58 abgestimmt.

## Patentansprüche

1. Leiterplattentrenneinrichtung (10) zum Vereinzeln von Leiterplatten (52) aus einem Leiterplattensubstrat (30), wobei das Leiterplattensubstrat (30) und die hieraus im Zuge einer Trennbearbeitung vereinzelten Leiterplatten (52) während der Trennbearbeitung auf einem Werkstückträger (12) gehalten sind, wobei eine Abdeckeinrichtung (44) vorgesehen ist, welche auf einer einer Grundbasis (14) des Werkstückträgers (12) abgewandten Seite des Leiterplattensubstrats (30) anordenbar oder angeordnet ist, wobei die Abdeckeinrichtung (44) mindestens einen Abdeckabschnitt (74) umfasst, welcher einen Leiterplattenabschnitt abdeckt und als Niederhalter wirksam ist, und wobei die Abdeckeinrichtung (44) mindestens eine Aussparung (62) umfasst, welche zur Trennbearbeitung des Leiterplattensubstrats (30) innerhalb eines von der Aussparung (62) begrenzten Freiraums (64) eine Zugangspassage (66) zu dem Leiterplattensubstrat (30) für eine Trenneinrichtung (68) bildet, wobei die Abdeckeinrichtung (44) an der Grundbasis (14) festlegbar und/oder auf der Grundbasis (14) abstützbar ist, **dadurch gekennzeichnet, dass** variabel auf der Grundbasis (14) positionierbare Zusatzhalteelemente (24) zur Festlegung der Abdeckeinrichtung (44) an der Grundbasis (14) und/oder Zusatzstützelemente (26) zur Abstützung der Abdeckeinrichtung (44) vorgesehen sind, wobei die Zusatzhalteelemente (24) und/oder Zusatzstützelemente (26) magnetisch mit der Grundbasis (14) zusammenwirkende Fußabschnitte (28) aufweisen.

2. Leiterplattentrenneinrichtung (10) nach Anspruch 1, **dadurch gekennzeichnet, dass** der Werkstückträger (12) mit der Grundbasis (14) zusammenwirkende Halteelemente (20) und/oder Stützelemente (22) für das Leiterplattensubstrat (30) umfasst.

3. Leiterplattentrenneinrichtung (10) nach Anspruch 2, **dadurch gekennzeichnet, dass** die Zusatzhalteelemente (24) mit den Halteelementen (20) und/oder dass die Zusatzstützelemente (26) mit den Stützelementen (22) baugleich sind, wobei die Zusatzhalteelemente (24) und/oder die Zusatzstützelemente (26) eine größere wirksame Bauhöhe aufweisen als die Halteelemente (20) und/oder Stützelemente (22), sodass die Abdeckeinrichtung (44) in einem größeren Abstand zu der Grundbasis (14) festlegbar und/oder abstützbar ist als das Leiterplattensubstrat (30).

4. Leiterplattentrenneinrichtung (10) nach Anspruch 2 oder 3, **dadurch gekennzeichnet, dass** Fußabschnitte (28) der Halteelemente (20) und/oder der Stützelemente (22) magnetisch mit der Grundbasis (14) zusammenwirken.

5. Leiterplattentrenneinrichtung (10) nach einem der voranstehenden Ansprüche, **dadurch gekennzeichnet, dass** die Abdeckeinrichtung (44) ein durch Anordnung von Abdeckabschnitten (74) und Aussparungen (62) definiertes Layout aufweist, welches derart auf ein Leiterplattensubstrat (30) abgestimmt ist, dass zumindest ein Abschnitt der Kontur (54) einer im Zuge der Trennbearbeitung vereinzelten Leiterplatte (52) von mindestens einem Abdeckabschnitt (74) der Abdeckeinrichtung (44) abgedeckt ist.

6. Leiterplattentrenneinrichtung (10) nach einem der voranstehenden Ansprüche, **dadurch gekennzeichnet, dass** die Abdeckeinrichtung (44) mindestens eine Zusatzaussparung (78) aufweist, welche zur Aufnahme eines an dem Leiterplattensubstrat (30) befestigten Bauteils (58) dient, sodass während der Trennbearbeitung dieses Bauteil (58) die Zusatzaussparung (78) der Abdeckeinrichtung (44) durchsetzt.

7. Leiterplattentrenneinrichtung (10) nach einem der voranstehenden Ansprüche, **dadurch gekennzeichnet, dass** die Trenneinrichtung (68) mechanisch wirksam ist und dass eine Absaugeinrichtung (76) zum Absaugen von mittels der Trenneinrichtung (68) im Zuge der Trennbearbeitung des Leiterplattensubstrats (30) erzeugten Leiterplattensubstratpartikeln oder -spänen vorgesehen ist.

8. Leiterplattentrenneinrichtung (10) nach einem der voranstehenden Ansprüche, **dadurch gekennzeichnet, dass** eine magazinartige Aufnahme (18) für eine Mehrzahl von Halteelementen (20) und/oder Stützelementen (22) und für eine Mehrzahl von Zusatzhalteelementen (24) und/oder Zusatzstützelementen (26) vorgesehen ist, und dass eine Handhabungseinrichtung vorgesehen ist, mittels welcher zum einen die Halteelemente (20) und/oder Stützelemente (22) und zum anderen die Zusatzhalteelemente (24) und/oder Zusatzstützelemente (26) aus der Aufnahme (18) entnehmbar und auf der Grundbasis (14) positionierbar sind, wobei die Entnahme und Positionierung sowohl der Halteelemente (20) und/oder Stützelemente (22) als auch der Zusatzhalteelemente (24) und/oder Zusatzstützelemente (26) numerisch gesteuert durchführbar ist.

9. Leiterplattentrenneinrichtung (10) nach einem der voranstehenden Ansprüche, **dadurch gekennzeichnet, dass** die Leiterplatten (52) bestückt sind.

10. Leiterplattentrenneinrichtung (10) nach einem der voranstehenden Ansprüche, **dadurch gekennzeichnet, dass** die Abdeckeinrichtung (44) plattenförmig ausgebildet ist.

## Claims

1. A circuit board separation device (10) for separating circuit boards (52) from a circuit board substrate (30), in which the circuit board substrate (30) and the circuit boards (52) separated from it in the course of a separation operation are retained on a workpiece holder (12), and a covering (44) is provided which can be or is disposed on a side of the circuit board substrate (30) facing away from a base (14) of the workpiece holder (12), and the covering (44) includes at least one covering portion (74) which covers a portion of the circuit board and acts as a holding-down device, and the covering (44) includes at least one recess (62), which for the operation of separation from the circuit board substrate (30) forms a passage (66), in a free space (64) defined by a recess (62), for access to the circuit board substrate (30) by a separation device (68), and the covering (44) can be fixed on the base (14) and/or braced on the base (14), **characterized in that** additional retainer elements (24) for fixing the covering (44) to the base (14) and/or additional bracing elements (26) for bracing the covering (44) are provided which are variably positionable on the base (14), and the additional retainer elements (24) and/or additional bracing elements (26) have foot portions (28) that cooperate magnetically with the base (14).

2. The circuit board separation device (10) of claim 1, **characterized in that** the workpiece holder (12) includes retainer elements (20) and/or bracing elements (22) for the circuit board substrate (30) that cooperate with the base (14).

3. The circuit board separation device (10) of claim 2, **characterized in that** the additional retainer elements (24) are structurally identical to the retainer elements (20) and/or that the additional bracing elements (26) are structurally identical to the bracing elements (22), and the retainer elements (24) and/or the bracing elements (26) have a greater effective structural height than the retainer elements (20) and/or bracing elements (22), so that the covering (44) can be fixed and/or braced at a greater distance from the base (14) than the circuit board substrate (30) can.

4. The circuit board separation device (10) of claim 2 or 3, **characterized in that** foot portions (28) of the retainer elements (20) and/or of the bracing elements (22) cooperate magnetically with the base (14).

5. The circuit board separation device (10) of one of the foregoing claims, **characterized in that** the covering (44) has a layout, defined by the disposition of covering portions (74) and recesses (62), which is adapted to a circuit board substrate (30) in such a way that at least a portion of the contour (54) of a circuit board (52) separated in the course of the separation operation is covered by at least one covering portion (74) of the covering (44).

6. The circuit board separation device (10) of one of the foregoing claims, **characterized in that** the covering (44) has at least one additional recess (78), which serves to receive a component (58) secured to the circuit board substrate (30), so that during the separation operation of this component (58), the additional recess (78) extends through the covering (44).

7. The circuit board separation device (10) of one of the foregoing claims, **characterized in that** the separation device (68) operates mechanically and that a suction device (76) for removal by suction of circuit board substrate particles or chips, created by means of the separation device (68) in the course of the operation of separating the circuit board substrate (30), is provided.

8. The circuit board separation device (10) of one of the foregoing claims, **characterized in that** a magazinelike receptacle (18) for a plurality of retainer elements (20) and/or bracing elements (22) and for a plurality of additional retainer elements (24) and/or additional bracing elements (26) is provided, and that a manipulator is provided, by means of which, first, the retainer elements (20) and/or bracing elements (22) and, second, the additional retainer elements (24) and/or additional bracing elements (26) can be removed from the receptacle (18) and can be positioned on the base (14), and the removal and positioning of not only the retainer elements (20) and/or bracing elements (22) but also the additional retainer elements (24) and/or additional bracing elements (26) can be performed under numerical control.

9. The circuit board separation device (10) of one of the foregoing claims, **characterized in that** the circuit boards (52) are assembled.

10. The circuit board separation device (10) of one of the foregoing claims, **characterized in that** the covering (44) is embodied as platelike.

## Revendications

1. Dispositif de séparation de cartes de circuit imprimé (10) permettant de séparer des cartes de circuit imprimé (52) d'un substrat à cartes de circuit imprimé (30), le substrat à cartes de circuit imprimé (30) et les cartes de circuit imprimé (52) séparées de celui-ci au cours de l'opération de séparation étant retenues sur un porte-pièce (12), un dispositif de recouvrement (44) pouvant être ou étant disposé sur une face du substrat à cartes de circuit imprimé (30) opposée à une base (14) du porte-pièce (12), le dispositif de recouvrement (44) comprenant au moins une partie de recouvrement (74) recouvrant une partie de la carte de circuits imprimés et fonctionnant comme un serre-flan, et le dispositif de recouvrement (44) comprenant au moins un évidement (62) formant, pour l'opération de séparation du substrat à cartes de circuit imprimé (30), à l'intérieur d'un espace libre (64) délimité par l'évidement (62), un passage d'accès (66) au substrat à cartes de circuit imprimé (30) pour un dispositif de séparation (68), le dispositif de recouvrement (44) pouvant être fixé à la base (14) et/ou pouvant s'appuyer sur la base (14), **caractérisé en ce que** des éléments de retenue additionnels (24) pouvant être positionnés sur la base (14) avec possibilités de variation et destinés à fixer le dispositif de recouvrement (44) sur la base (14) et/ou des éléments d'appui supplémentaires (26) sont destinés à soutenir le dispositif de recouvrement (44), les éléments de retenue supplémentaires (24) et/ou les éléments d'appui supplémentaires (26) comprenant des parties pied (28) coopérant magnétiquement avec la base (14).

2. Dispositif de séparation à cartes de circuit imprimé (10) selon la revendication 1, **caractérisé en ce que** le porte-pièce (12) comprend des éléments de retenue (20) coopérant avec la base (14) et/ou des éléments d'appui (22) pour le substrat à cartes de circuit imprimé (30).

3. Dispositif de séparation à cartes de circuit imprimé (10) selon la revendication 2, **caractérisé en ce que** les éléments de retenue supplémentaires (24) présentent la même construction que les éléments de retenue (20) et/ou en ce que les éléments d'appui supplémentaires (26) présentent la même construction que les éléments d'appui (22), les éléments de retenue supplémentaires (24) et/ou les éléments d'appui supplémentaires (26) présentant une hauteur de construction effective plus grande que celle des éléments de retenue (20) et/ou des éléments d'appui (22), de sorte que le dispositif de recouvrement (44) peut être fixé et/ou soutenu à une plus grande distance de la base (14) que le substrat à cartes de circuit imprimé (30).

4. Dispositif de séparation à cartes de circuit imprimé (10) selon la revendication 2 ou 3, **caractérisé en ce que** les parties pied (28) des éléments de retenue (20) et/ou les éléments d'appui (22) coopèrent magnétiquement avec la base (14).

5. Dispositif de séparation à cartes de circuit imprimé (10) selon l'une quelconque des revendications précédentes, **caractérisé en ce que** le dispositif de recouvrement (44) présente une configuration définie par l'agencement de parties de recouvrement (74) et d'évidements (62), ladite configuration étant adaptée à un substrat à cartes de circuit imprimé (30), de telle sorte qu'au moins une partie du contour (54) d'une carte de circuits imprimés (52) séparée au cours de l'opération de séparation est recouverte par au moins une partie de recouvrement (74) du dispositif de recouvrement (44).

6. Dispositif de séparation à cartes de circuit imprimé (10) selon l'une quelconque des revendications précédentes, **caractérisé en ce que** le dispositif de recouvrement (44) comprend au moins un évidement supplémentaire (78) servant à recevoir un composant (58) fixé sur le substrat à cartes de circuit imprimé (30), de sorte que pendant l'opération de séparation, ce composant (58) traverse l'évidement supplémentaire (78) du dispositif de recouvrement (44).

7. Dispositif de séparation à cartes de circuit imprimé (10) selon l'une quelconque des revendications précédentes, **caractérisé en ce que** le dispositif de séparation (68) a une action mécanique et **en ce qu'**un dispositif d'aspiration (76) est destiné à aspirer les particules ou copeaux de substrat à cartes de circuit imprimé produits par le dispositif de séparation (68) au cours de l'opération de séparation du substrat à cartes de circuit imprimé (30).

8. Dispositif de séparation de cartes de circuit imprimé (10) selon l'une quelconque des revendications précédentes, **caractérisé en ce qu'**un logement (18) du type magasin est prévu pour une pluralité d'éléments de retenue (20) et/ou d'éléments d'appui (22) et pour une pluralité d'éléments de retenue supplémentaires (24) et/ou d'éléments d'appui supplémentaires (26), et **en ce qu'**un dispositif de manutention permet de retirer d'une part les éléments de retenue (20) et/ou les éléments d'appui (22) et d'autre part les éléments de retenue supplémentaires (24) et/ou les éléments d'appui supplémentaires (26) du logement (18) et de les positionner sur la base (14), le retrait et le positionnement à la fois des éléments de retenue (20) et/ou des éléments d'appui (22) et des éléments de retenue supplémentaires (24) et/ou des éléments d'appui supplémentaires (26) pouvant être mis en oeuvre au moyen d'une commande numérique.

9. Dispositif de séparation à cartes de circuit imprimé (10) selon l'une quelconque des revendications précédentes, **caractérisé en ce que** les cartes à circuit imprimé (52) sont équipées.

10. Dispositif de séparation à cartes de circuit imprimé (10) selon l'une quelconque des revendications précédentes, **caractérisé en ce que** le dispositif de recouvrement (44) est conçu en forme de plaque.
